# EUROPÄISCHE PATENTSCHRIFT

(11) **EP 3 631 873 B1**
(45) Veröffentlichungstag und Bekanntmachung des Hinweises auf die Patenterteilung: **05.08.2026**
(21) Anmeldenummer: 18730992.7
(22) Anmeldetag: 31.05.2018
(51) Int. Cl.: H10K 85/60

(54) **POLYPHENOLE UND POLYAMINO-DERIVATE IN ORGANISCHEN OPTOELEKTRONISCHEN BAUELEMENTEN**
POLYPHENOLS AND POLYAMINO DERIVATIVES IN ORGANIC OPTOELECTRONIC COMPONENTS
POLYPHÉNOLE ET DÉRIVÉS DE POLYAMINO DANS DES ÉLÉMENTS CONSTITUTIFS OPTOÉLECTRONIQUES ORGANIQUES

(30) Priorität: 31.05.2017 EP 17173859
(43) Veröffentlichungstag der Anmeldung: 08.04.2020
(73) Patentinhaber: Heliatek GmbH, 01139 Dresden (DE)
(72) Erfinder: MATTERSTEIG, Gunter, 89077 Ulm (DE); WEISS, Andre, 01139 Dresden (DE); WALZER, Karsten, 01139 Dresden (DE); PFEIFFER-JACOB, Martin, 01139 Dresden (DE); LEVICHKOVA, Marieta, 01139 Dresden (DE); GERDES, Olga, 89077 Ulm (DE); HILDEBRANDT, Dirk, 89077 Ulm (DE); D'SOUZA, Daniel, 01139 Dresden (DE); MIRLOUP, Antoine, 89077 Ulm (DE)
(86) Internationale Anmeldenummer: PCT/EP2018/064391
(87) Internationale Veröffentlichungsnummer: WO 2018/220148

(56) Entgegenhaltungen:
- WO-A1-2010/044122
- KR-A- 20150 137 730
- US-A1- 2009 159 120
- THEKINNEYDATH RAJAN HEERA ET AL: "Molecular orbital evaluation of charge flow dynamics in natural pigments based photosensitizers", JOURNAL OF MOLECULAR MODELING, SPRINGER, DE, vol. 16, no. 3, 11 August 2009 (2009-08-11), pages 523 - 533, XP019783744, ISSN: 0948-5023
- RAMAMOORTHY RAJA ET AL: "Betalain and anthocyanin dye-sensitized solar cells", JOURNAL OF APPLIED ELECTROCHEMISTRY, SPRINGER, DORDRECHT, NL, vol. 46, no. 9, 4 June 2016 (2016-06-04), pages 929 - 941, XP036025416, ISSN: 0021-891X, [retrieved on 20160604], DOI: 10.1007/S10800-016-0974-9
- KUMARA G R A ET AL: "Shiso leaf pigments for dye-sensitized solid-state solar cell", SOLAR ENERGY MATERIALS AND SOLAR CELLS, ELSEVIER SCIENCE PUBLISHERS, AMSTERDAM, NL, vol. 90, no. 9, 23 May 2006 (2006-05-23), pages 1220 - 1226, XP028002186, ISSN: 0927-0248, [retrieved on 20060523], DOI: 10.1016/J.SOLMAT.2005.07.007
- LAILY A R N ET AL: "Poly (3-Dodecylthiophene)/Natural Dye Bulk Heterojunction Organic Solar Cell: An Electrical Conductivity, and Hall Effect Study", PROCEDIA CHEMISTRY, ELSEVIER, AMSTERDAM, NL, vol. 19, 24 March 2016 (2016-03-24), pages 2 - 9, XP029471411, ISSN: 1876-6196, DOI: 10.1016/J.PROCHE.2016.03.003

## Beschreibung

### Gebiet der Erfindung

Die Erfindung beschreibt optoelektronische Bauelemente, speziell organische optoelektronische Bauelemente, mit Polyphenolen und Polyamino-Derivaten.

### Stand der Technik

Organische optoelektronische Bauelemente ermöglichen es beispielsweise als Solarzelle unter Ausnutzung des photoelektrischen Effekts Licht in elektrischen Strom umzuwandeln. Für die Umwandlung werden organische Halbleitermaterialien benötigt, die hinreichend gute Absorptionseigenschaften besitzen. Diese Absorbermaterialien sind bevorzugt kleine organische Moleküle, deren optische und elektronische Eigenschaften stark von der Orientierung dieser Moleküle abhängen.

Um effiziente organische photoaktive Bauelemente herzustellen, bestehen diese oft aus mehreren gestapelten Zellen in einer Tandem-oder Mehrschichtstruktur zwischen zwei Elektroden, wobei die photoaktiven Schichten, d.h. die Schichten einer Zelle, die Licht absorbieren und einen Beitrag zur Stromgewinnung beitragen, ebenfalls aus mehreren Schichten bestehen können. Das organische optoelektronische Bauelement, kann in einer Zelle neben den photoaktiven Schichten, beispielsweise noch dotierte und undotierte Ladungsträgertransportschichten, und/oder Passivierungsschichten umfassen. Als photoaktive Materialien können Donor- und Akzeptormaterialien auf Basis kleiner Moleküle verwendet werden. Die Erfinder verstehen als Absorbermaterialien aus der Basis kleiner Moleküle Oligomere. Diese Oligomere sind bevorzugt Akzeptor-Donor-Akzeptor'- oder Donor-Akzeptor-Donor'-Oligomere mit mindestens einem ausgedehnten Donor- bzw. ausgedehnten Akzeptor-Block. Diese Absorbermaterialien umfassen eine wohl definierte Anzahl von Monomeren, typischerweise kleiner zehn, und weisen eine wohldefinierte Masse auf, typischerweise von weniger als 1500g/mol, bevorzugt kleiner als 1200g/mol, und sind frei von undefinierten, möglicherweise reaktiven Gruppen am Ende der Molekülkette, wie sie als Nebenprodukt einer Polymerisations-Kettenreaktion in Polymeren vorliegen können. Vorteile dieser Absorbermaterialien auf der Basis kleiner Moleküle sind eine Verdampfbarkeit im Vakuum und damit eine verbundene Möglichkeit der Reinigung durch Gradientensublimation. Damit besteht die Möglichkeit beliebig komplexe Multischichtsysteme durch sequentielles Verdampfen verschiedener und reiner Materialien herzustellen. Diese Absorbermaterialien ermöglichen weiterhin photoaktive Heteroübergänge, vgl. WO 2006 092 134. Eine photoaktive Schicht in einem photoaktiven Schichtstapel einer Zelle kann nur ein Akzeptor- oder nur ein Donor-Absorbermaterial umfassen oder auch eine Kombination mehrerer Absorbermaterialien unterschiedlichen Typs umfassen. Weiterhin können den Absorberschichten Materialien zugesetzt werden, um die Absorptionseigenschaften zu verbessern. Absorbermaterialien auf Basis kleiner Moleküle sind beispielsweise in WO 2006 092 134, WO 2011 161 262 oder WO 2014 128 277 beschrieben. Organische optoelektronische Bauelemente sind beispielsweise in WO 2004 083 958 oder WO 2011 138 021 offengelegt.

Eine besonders starke Lichtabsorption wird erzielt, wenn sich die molekularen Übergangsdipolmomente der Absorbermoleküle orthogonal zur einfallenden Lichtwelle anordnen.Neben der Lichtabsorption ist auch der Ladungstragsport aus dem Absorbermolekül in die angrenzenden Schichten hin zu den Elektroden wichtig. Dieser wird besonders groß, wenn sich die in den Absorbern vorhandenen pi-Elektronensysteme mit dem pi-Elektronensystemen der darunter liegenden Schicht überlappen. Diese Anordnung bezeichnen wir als "face-on" liegend. Diese Anordnung ist bevorzugt. Im Gegensatz dazu ist die Anordnung, die als "edge-on" liegend bezeichnet wird, bei der zwar der molekulare Dipol ebenso wie bei "face-on" orthogonal zur einfallenden Lichtwelle ist, jedoch die pi-Elektronensysteme des Absorbers orthogonal zur unterliegenden Schicht angeordnet sind, was einen effektiven Ladungsübertrag zwischen den pi-Elektronensystemen unterdrückt. Das Wachstum der Absorbermaterialien auf Substraten oder anderen Schichten wird bestimmt durch zwischenmolekulare Kräfte, die einerseits die Wachstumsrichtung und die Orientierung der angrenzenden Moleküle zueinander bestimmen. Dazu ist es möglich eine, orientierungsbildende Schicht, die auch als Templatschicht bezeichnet wird, einzufügen.

Die Erfinder haben festgestellt, dass einzelne Absorbermaterialien, überwiegend Donormaterialien, Probleme mit einer "face-on" Ausrichtung, d.h. einer Ausrichtung orthogonal zur einfallenden Lichtwelle, haben können. Solche Donormaterialien umfassen, beispielsweise heterocyclische Ringe, wie beispielsweise Phthalocyanine, Thiophen-, Furan und/oder Pyrrolringe, und sind bevorzugt Akzeptor-Donor-Akzeptor-Verbindungen, wie sie beispielsweise in WO 2006 092 134 offengelegt sind. Durch die häufig nicht "face-on" wachsende Ausrichtung der Absorbermaterialien, wird in der mit diesen Materialien hergestellten Solarzelle keine optimale Nutzung dieser Absorbermaterialien erreicht.

WO 2011 025 567 offenbart organische optoelektronische Bauelemente, die aus einer strukturbildenden Schicht auf einer Elektrodenschicht bestehen, auf der dann ein photoaktives Schichtsystem aus Akzeptor-und Donormolekülen aufgebracht ist, so dass durch die angrenzende strukturbildende Schicht eine geordnete molekulare Ausrichtung des Akzeptor- oder Donormaterials erfolgt. WO 2011 025 567 schlägt als strukturbildende Materialien Acene, Perylene, beispielsweise Diindenoperylene (DIP) oder 3,4,9,10-perylene-tetracarboxylicaciddianhydride (PTCDA), Polyphenylene, oder Coronen vor.

US 2002 098 346 offenbart Mehrschichtstrukturen auf einem Substrat, wobei eine erste monomolekulare Schicht ein erstes strukturbildendes Material enthält und die Orientierungsrichtung dieser Schicht definiert, wobei ein chemisch reaktives Monomer zu einer gerichteten chemischen Reaktion auf der Oberfläche führt und damit eine geordnete Molekülstruktur erzielt. Dadurch ist US 2002 098 346 in seiner Anwendbarkeit beschränkt auf Stoffe, die chemisch reagieren können. Sie ist nicht anwendbar auf reine Physisorption ohne chemische Reaktion.

WO 2010 044 122 offenbart organische Solarzellen, auf der Basis von Farbstoffen, die eine photo-elektrochemische Reaktion hervorrufen. [Ramaoorthy, R. u.a.: Betalain and anthrocyanin dye-sentizized solar cells. J. Appl. Electrochemica. (2016) 46-929-941.] und [Kumara G.R.A. u.a.: Shiso leaf pigments for dye-sensitized solid-state solar cells. Solar Energy materials & Solar cells 90 (2006) 1220-1226.] offenbaren ebenfalls mit natürlichen Farbstoffen hergestellte Farbstoff-Solarzellen, bei denen beispielsweise eine TiO₂-Schicht in die Farbstofflösung getaucht wird. Sie offenbaren damit, dass die natürlichen Farbstoffe in Verbindung mit TiO₂ Licht absorbieren.

US 2009/159120 A1 offenbart Quantum Dot Solarzellen mit konjugiert verbrückten Molekülen. Alizarin wird als Verbindung für eine "bridge layer 14" vorgeschlagen, die zwischen einer Transportschicht und einer Quantum Dot Schicht angeordnet ist. Die "bridge layer 14" ist jedoch keine Templatschicht, die direkt an eine photoaktive Schicht angrenzt.

### Darstellung der Erfindung

### Technische Aufgabe

Ziel der vorgelegten Erfindung ist, Materialien anzugeben, die zu einer verbesserten Orientierung der Absorbermoleküle auf der Basis kleiner Moleküle in der photoaktiven Schicht, auch als Absorberschicht bezeichnet, führen und damit eine Erhöhung des Kurzschlussstroms ermöglichen, wobei die Leerlaufspannung des optoelektronischen Bauelements zumindest nicht verringert wird.

### Offenbarung der Erfindung und technischer Wirkung der Erfindung

Die technische Aufgabe wird gelöst durch die Verwendung von Polyphenolen und/oder Polyamino-aromaten oder -heteroaromaten, die an Absorbermaterialien angrenzen, in organischen optoelektronischen Bauelementen, wie in den Ansprüchen definiert, damit ein besseres face-on Wachstum der Absorbermaterialien erreicht wird.

Durch die Beschränkung der US 2002 098 346 in seiner Anwendbarkeit auf Stoffe, die chemisch reagieren können, ist sie nicht anwendbar auf reine Physisorption ohne chemische Reaktion, welche der vorliegenden Erfindung zugrunde liegt.

Als face-on wird hierbei der Fall bezeichnet, bei dem die pi-Elektronensysteme der Materialien der verwendeten Polyphenol- Schicht und/oder Polyaminoderivat-Schicht einen pi-pi-Überlapp mit den pi-Elektronensystem(en) der darauffolgenden Absorberschicht bilden.

Es werden optoelektronische Bauelemente beschrieben, die Verbindungen der Struktur (I) umfassen, die an Absorbermaterialien angrenzen: 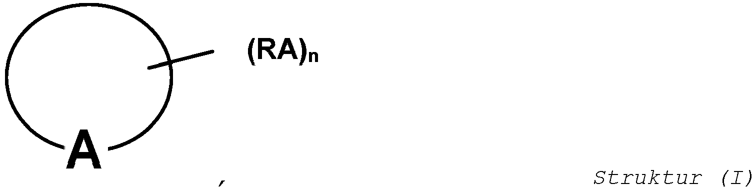
- wobei A den Rest eines Zyklus symbolisiert, der ganz oder teilweise ein carbocyclisches oder heterocyclisches aromatisches, monocyclisches oder polycyclisches System bildet,
- wobei dieser Zyklus mindestens n > 1 Reste RA umfasst, und diese Reste RA jeweils unabhängig ausgewählt sind aus Hydroxy- und Aminogruppen.

Ebenfalls werden Verbindungen beschrieben, deren Reste RA aus Hydroxygruppen ausgewählt sind, in den organischen optoelektronischen Bauelementen eingesetzt. Die eingesetzten Verbindungen sind bevorzugt Verbindungen der allgemeinen Struktur II: 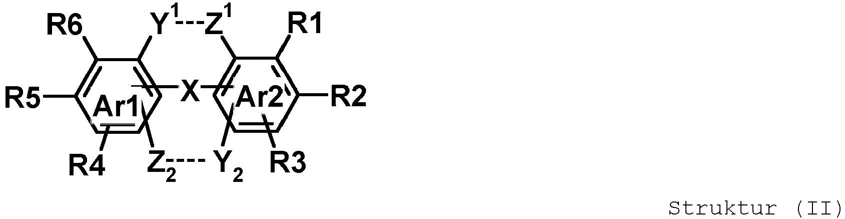
- die zwei oder mehr verbundene aromatischen oder heteroaromatische Ringe (Ar1, Ar2), bevorzugt Benzolringe, besitzen, die jeweils mindestens zwei Hydroxygruppen und/oder Aminogruppen umfassen,
- wobei die aromatischen Ringe (Ar1, Ar2) sowohl durch eine Einfachbindung (-X-) verknüpft als auch direkt anelliert sein können,
- R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Bei den anellierten Strukturen handelt es sich vorzugsweise um substituierte Naphthalenderivate (II.1) und Anthracenderivate (II.2), die sowohl verbrückt als auch unverbrückt sein können. Sind YI, ZI oder RI mit I > 1 nicht explizit einer Stelle zugeordnet, können die Substituenten an beliebigen Stellen im zugeordneten Ring, angeordnet sein: 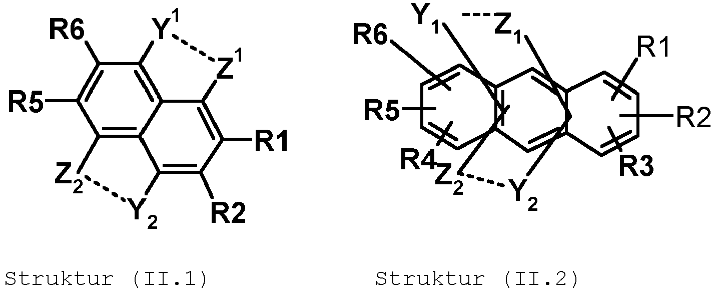
- wobei R1 bis R6 ausgewählt sind aus H, OH, NH₂;
- Y1 ausgewählt ist aus CH, CH₂, CO;
- Y2 ausgewählt ist aus CH, CH₂, CO, H;
- Z1 ausgewählt ist aus CH, CH₂, CO, O, NH;
- Z2 ausgewählt ist aus CH, CH₂, CO, O, NH, H;
- wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Die Verbrückung der aromatischen Ringe (Ar1 und Ar2) gemäß Struktur (II), welche mittels einer Einfachbindung (-X-) verknüpft sind, kann unabhängig
- durch eine oder zwei Doppelbindung(en) unter Bildung eines Phenanthrens oder Pyrens,
- durch einen oder mehrere anellierte aromatische oder heteroaromatische Ringe unter Bildung eines Triphenylens oder Dibenzopyrens,
- durch Alkylgruppen mit ein bis drei C-Atomen,
- durch Aryloxy- oder Arylaminogruppen
- durch Alkoxygruppen unter Bildung von Pyranen, durch Carbonyl-, Carboxy- oder Carbamoylgruppen unter Bildung von Ketonen, Chinonen, Anthrachinonen (II.3), Lactonen und Lactamen, erfolgen. 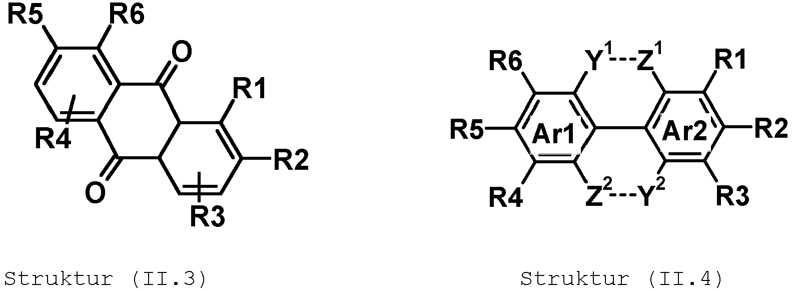
   - wobei Ar1 und Ar2 zwei oder mehr verbundene aromatischen oder heteroaromatische Ringe (Ar1, Ar2), bevorzugt Benzolringe, sind, die jeweils mindestens zwei Hydroxygruppen und/oder Aminogruppen umfassen,
   - R1 bis R6 ausgewählt sind aus H, OH, NH₂;
   - Y1 ausgewählt ist aus CH, CH₂, CO;
   - Y2 ausgewählt ist aus CH, CH₂, CO, H;
   - Z1 ausgewählt ist aus CH, CH₂, CO, O, NH;
   - Z2 ausgewählt ist aus CH, CH₂, CO, O, NH, H;
   - wobei die Verknüpfungen Y1 ... Z1 und/oder Y2 ... Z2 sowohl kovalenter als auch nicht kovalenter Natur sein können, wobei im ersten (kovalenten) Fall Y1 ... Z1 und/oder Y2 ... Z2 ebenso eine substituierte aromatische oder heteroaromatische Mono-, Di-oder Trihydroxyverbindung bilden können.

Die technische Aufgabe wird erfindungsgemäß gelöst indem ein organisches optoelektronisches Bauelement, umfassend zwei Elektroden und dazwischen angeordnet mindestens ein photoaktives Schichtsystem, bereitgestellt wird, dieses umfassend mindestens eine photoaktive Schicht, umfassend Absorbermaterialien auf der Basis kleiner Moleküle, wobei das Absorbermaterial A-D-A-Moleküle sind, wobei die photoaktive Schicht an eine Templatschicht angrenzt, wobei die Templatschicht eine Verbindung der Struktur (II.1), (II.2), (II.3) und/oder (II.4) umfasst, wobei: 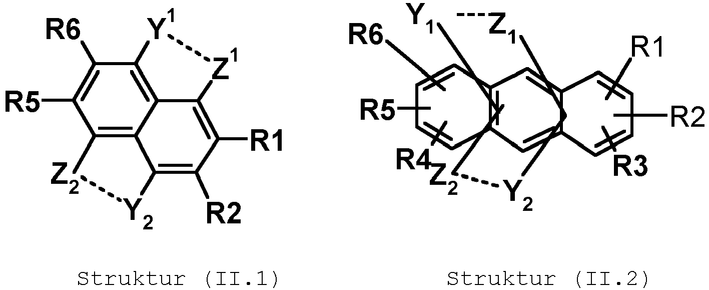 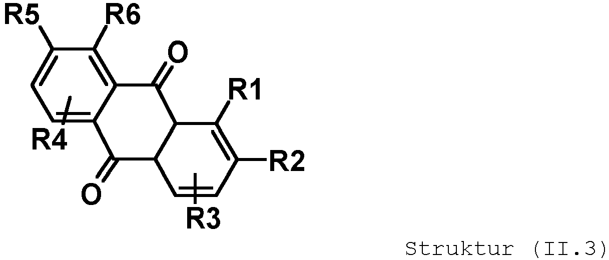 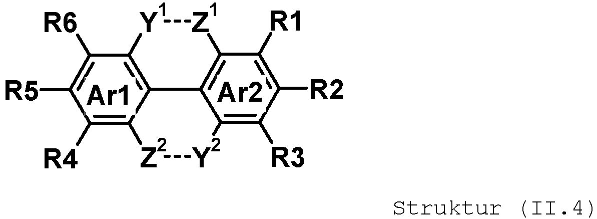
Ar1 und Ar2 zwei oder mehr verbundene aromatische oder heteroaromatische Ringe (Ar1, Ar2), bevorzugt Benzolringe, sind, die jeweils mindestens zwei Hydroxygruppen und/oder Aminogruppen umfassen,
R1 bis R6 ausgewählt sind aus H, OH, NH₂;
Y1 ausgewählt ist aus CH, CH₂, CO;
Y2 ausgewählt ist aus CH, CH₂, CO, H;
Z1 ausgewählt ist aus CH, CH₂, CO, O, NH;
Z2 ausgewählt ist aus CH, CH₂, CO, O, NH, H;
wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Unter bevorzugten erfindungsgemäßen Verbindungen auf der Basis von Polyphenolen werden insbesondere Verbindungen der allgemeinen Struktur (II.4) verstanden, besonders bevorzugt Ellagsäure.

Unter den erfindungsgemäß verwendeten Verbindungen auf Basis von Polyamino-Derivaten werden insbesondere folgende Verbindungen verstanden:
- Polyamino-aromate oder -heteroaromate, beschrieben durch die allgemeine Struktur (I) wobei A den Rest eines Zyklus symbolisiert, der ganz oder teilweise ein carbocyclisches oder heterocyclisches aromatisches, monocyclisches oder polycyclisches System bildet, und wobei dieser Zyklus mindestens 2 Aminogruppen umfasst.

Als weitere Lösung der technischen Aufgabe ist die Herstellung organischer optoelektronischer Bauelemente umfassend eine der erfindungsgemäßen Verbindungen von Polyphenolen und/oder Polyamino-aromaten oder -heteroaromaten, die an Absorbermaterialien auf der Basis kleiner Moleküle angrenzen.

Erfindungsgemäß wird zur Herstellung des organischen optoelektronischen Bauelements während der Herstellung der Schichten des organischen optoelektronischen Bauelements
a) vor dem Auftragen mindestens einer Absorberschicht die Templatschicht, umfassend die mindestens eine Verbindung der Struktur (II.1), (II.2), (II.3) und/oder (II.4), auf bisher abgeschiedene Schichten aufgetragen, und/oder
b) gleichzeitig mit den Absorbermaterialien der mindestens einen Absorberschicht die mindestens eine Verbindung der Struktur (II.1), (II.2), (II.3) und/oder (II.4) auf bisher aufgebrachte Schichten aufgetragen.

### Vorteilhafte Wirkung der Erfindung

Durch die Verwendung der erfindungsgemäßen Strukturen als Templatschicht erfolgt eine bessere Ausrichtung des angrenzenden, im Anschluss an die Templatschicht aufgebrachten Absorbermaterials, so dass eine bessere Effizienz des optoelektronischen Bauelements erreicht wird.

Für Mehrschicht-OPV (OPV = organische Photovoltaik) wird eine face-on Orientierung der Moleküle erreicht, die eine optimale Lichtabsorption und verbesserte Ladungstransporteigenschaften gewährleisten. In OPV-Bauelementen kann die Erzeugung einer kristallinen Ordnung zu einer Erhöhung des Kurzschlussstromes (Isc) und der Leerlaufspannung (Voc) führen. So kann über die Kontrolle der molekularen kristallinen Orientierung der Absorberschichten, speziell der Donorschicht, eine Optimierung der Grenzorbitalniveaus, des Absorptionskoeffizienten, der Morphologie und der Excitonendiffusionslängen erzielt werden. Damit wird die Effizienz der Energieumwandlung verbessert. Eine pi-Stapel-Anordnung coplanarer, flachliegender Absorbermoleküle, die sich über mehrere Schichten (face-on growth) fortsetzt ist daher sehr erwünscht und wird durch die an die Absorbermaterialien angrenzenden erfindungsgemäßen Verbindungen begünstigt.

Um das Optimum sowohl der Donormolekül-Orientierung als auch der Morphologie zu erreichen, sollte die Templat-Donormolekül-Wechselwirkung sowohl stark genug sein, um eine face-on-Stapelung zu erreichen als auch schwach genug, um Filmrauheiten zu vermeiden. Es soll insbesondere der Ladungstransport senkrecht zum Substrat verbessert werden, was eine Erhöhung des Füllfaktors bewirkt, bzw. bei gleichbleibendem Füllfaktor höhere Schichtdicken ermöglicht, so dass somit mehr Photostrom generiert wird.

Die erfindungsgemäße Verwendung der Verbindungen mit obigem Substituentenmuster bilden über starke Wasserstoff-Brückenbindungen und bei gleichzeitig abgeschwächter pi-Stapelwechselwirkung Schichten mit flachliegenden Molekülen (face-on, horizontale Ausrichtung) im Unterschied zu Phthalocyaninen, Hexabenzocoronen und anderen mehrfach aromatisch und heteroaromatisch anellierten Scheibenmolekülen, bei denen durch die starke pi-pi-Stapelwechselwirkung der Moleküle untereinander diese coplanar stehen und sich senkrecht aufrichten (edge-on, vertikale Ausrichtung).

Die Erfinder zeigen am Beispiel einer Templatschicht, umfassend Ellagsäure, die eine der erfindungsgemäßen Verbindungen gemäß einer der oben genannten Strukturen darstellt, und vor der Absorberschicht auf den Schichtstapel aufgebracht wurde, dass Solarzellen mit Templatschicht einen höheren Wirkungsgrad als adäquate Solarzellen ohne Templatschicht haben.

Weiterhin konnten die Erfinder überraschend feststellen, dass Solarzellen sogar nur mit einer dünnen Templatschicht einen höheren Wirkungsgrad als identische Solarzellen ohne Templatschicht besitzen und gleichzeitig die Lebensdauer der Solarzellen erhöht werden kann.

### (Kurze Beschreibung der Zeichnungen)

Die Erfindung und die Ausführungsbeispiele werden mit Zeichnungen beschrieben. Die einzelnen Zeichnungen stellen dar:
- Fig. 1:: Röntgendiffraktogramm einer Templatschicht.
- Fig. 2, Fig. 3, Fig. 4:: Röntgendiffraktogramme von Proben mit und ohne Templatschicht
- Fig. 5, Fig. 6, Fig. 7, Fig. 8:: Strom-Spannungskurven von Solarzellen mit und ohne Templatschicht
- Fig. 9:: Beschleunigte Lebensdauermessung von Solarzellen mit und ohne einer Templatschicht
- Fig. 10:: Liste der in den Ausführungsbeispielen genannten Absorbermaterial-Moleküle
- Fig. 11:: 2D-Anordnungen von möglichen weiteren Materialien in einer Templatschicht

### Detaillierte Beschreibung der Erfindung

Die technische Aufgabe wird gelöst durch die Verwendung von Polyphenolen und/oder Polyamino-aromaten oder -heteroaromaten, die an Absorbermaterialien auf der Basis kleiner Moleküle angrenzen, in organischen optoelektronischen Bauelementen, damit ein besseres face-on Wachstum der Absorbermaterialien erreicht wird.

Analog wird die technische Aufgabe gelöst durch eine Schicht umfassend Polyphenole und/oder Polyamino-aromaten oder - heteroaromaten, wobei die Schicht mit diesen Verbindungen an Absorberschichten mit Absorbermaterialen auf der Basis kleiner Moleküle angrenzen und ein besseres face-on-Wachstum der Absorbermaterialien ermöglichen.

Die technische Aufgabe wird demnach erfindungsgemäß gelöst mit organischen optoelektronischen Bauelementen, umfassend zwei Elektroden und dazwischen angeordnet mindestens ein photoaktives Schichtsystem, dieses umfassend mindestens eine photoaktive Schicht, umfassend Absorbermaterialien auf der Basis kleiner Moleküle, wobei das Absorbermaterial A-D-A-Moleküle sind, wobei die photoaktive Schicht an eine Templatschicht angrenzt, wobei die Templatschicht eine Verbindung der Struktur (II.1), (II.2), (II.3) und/oder (II.4) umfasst, wobei: 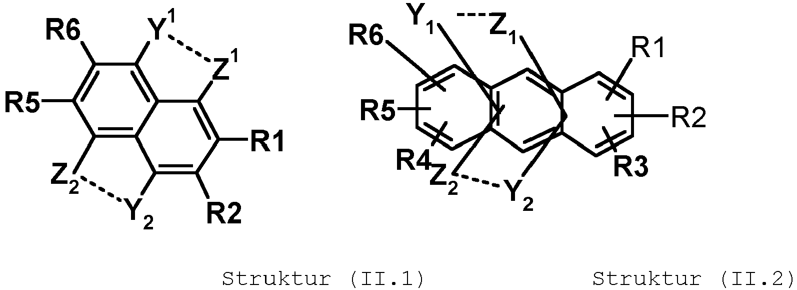 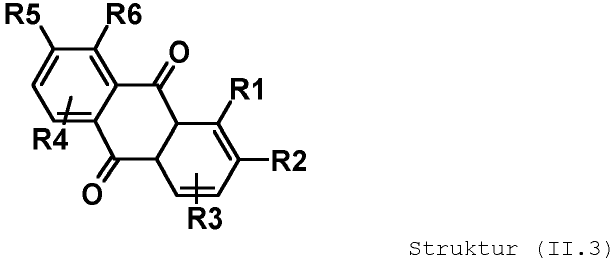 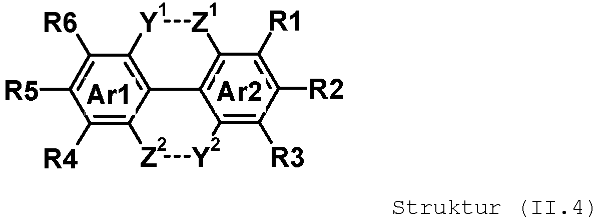
Ar1 und Ar2 zwei oder mehr verbundene aromatische oder heteroaromatische Ringe (Ar1, Ar2), bevorzugt Benzolringe, sind, die jeweils mindestens zwei Hydroxygruppen und/oder Aminogruppen umfassen, R1 bis R6 ausgewählt sind aus H, OH, NH₂;
Y1 ausgewählt ist aus CH, CH₂, CO;
Y2 ausgewählt ist aus CH, CH₂, CO, H;
Z1 ausgewählt ist aus CH, CH₂, CO, O, NH;
Z2 ausgewählt ist aus CH, CH₂, CO, O, NH, H;
wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

Erfindungsgemäß sind die organischen optoelektronischen Bauelemente mit mindestens einer der erfindungsgemäß vorgeschlagenen Verbindungen angrenzend an Absorbermaterialien auf der Basis kleiner Moleküle, angrenzend an Absorbermaterialien auf Basis A-D-A (Akzeptor - Donor - Akzeptor) oder D-A-D (Donor - Akzeptor - Donor). Die photoaktiven Schichten, die die Absorbermaterialien umfassen, können als
- Kombination von Einzelschichten, wobei eine Schicht mit einem Donormaterial an mindestens eine Schicht mit einem Absorbermaterial angrenzt, oder
- als Bulk heterojunction Schichten ausgeführt sein,
- oder eine Kombination aus beiden.

In einer Ausführungsform umfasst das optoelektronische Bauelement eine separate Schicht, als Templatschicht bezeichnet, umfassend die erfindungsgemäß verwendeten Verbindungen, wobei diese Templatschicht vor der angrenzenden photoaktiven Schicht (Absorberschicht), umfassend mindestens ein Absorbermaterial auf der Basis kleiner Moleküle, prozessiert wurde.

In einer weiteren Ausführungsform können innerhalb eines Tandem- oder Mehrschichtelements nur eine Zelle eine der vorgeschlagenen Verbindungen umfassen, oder in mindestens zwei Zellen gleiche und/oder verschiedenen der vorgeschlagenen Verbindungen verwendet werden.

In einer Kombination der obigen Ausführungsformen ist es möglich, dass eine Subzelle auch mehrere Templatschichten innerhalb ihres photoaktiven Schichtsstapels umfasst, wobei die Templatschichten gleiche oder unterschiedliche Materialien umfassen können.

Unter bevorzugten erfindungsgemäßen Verbindungen auf der Basis von Polyphenolen werden insbesondere Verbindungen der allgemeinen Struktur (II.4) verstanden.

Unter den erfindungsgemäß verwendeten Verbindungen auf Basis von Polyamino-derivaten werden insbesondere folgende Verbindungen verstanden:
- Polyamino-aromate oder -heteroaromate, beschrieben durch die allgemeine Struktur (I) wobei A den Rest eines Zyklus symbolisiert, der ganz oder teilweise ein carbocyclisches oder heterocyclisches aromatisches, monocyclisches oder polycyclisches System bildet, und wobei dieser Zyklus mindestens 2 Reste auf Basis von Aminogruppen umfasst.

Beispiele für erfindungsgemäße verwendete Polyphenole sind in Tabelle 1 gezeigt.

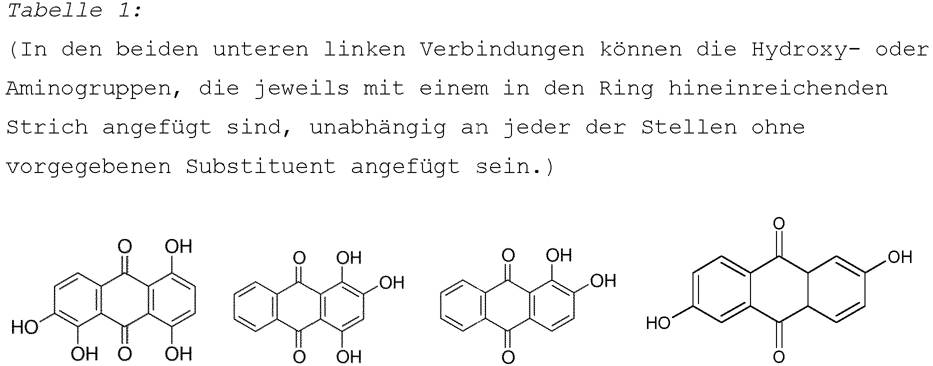

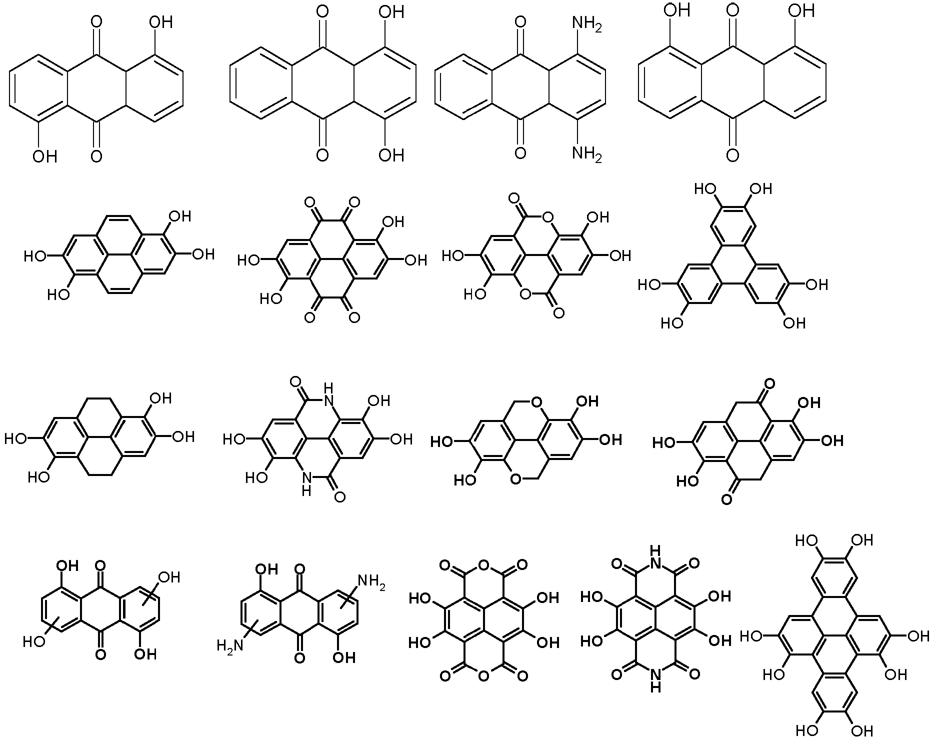

Als weitere verwendbare Verbindungen gemäß der Struktur (I) werden folgende Verbindungen angegeben:

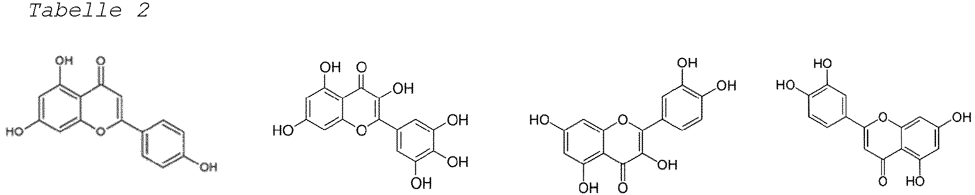

Die meisten der in den beiden Tabellen benannten Verbindungen sind bekannt und käuflich erwerbbar.

Ebenso erscheinen folgende natürliche Stoffe als Verbindungen zur Lösung der technischen Aufgabe geeignet, weil diese ebenfalls eine entsprechende Anordnung begünstigen:

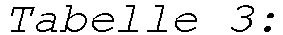

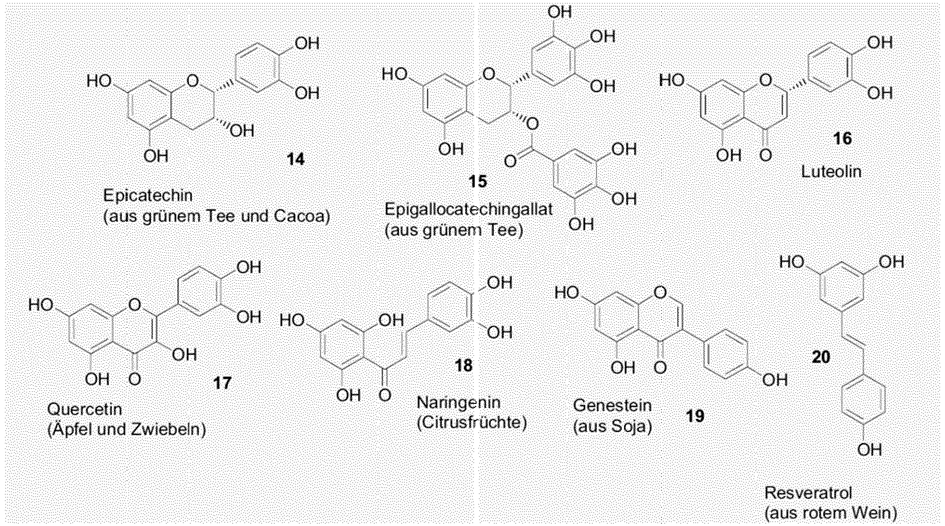

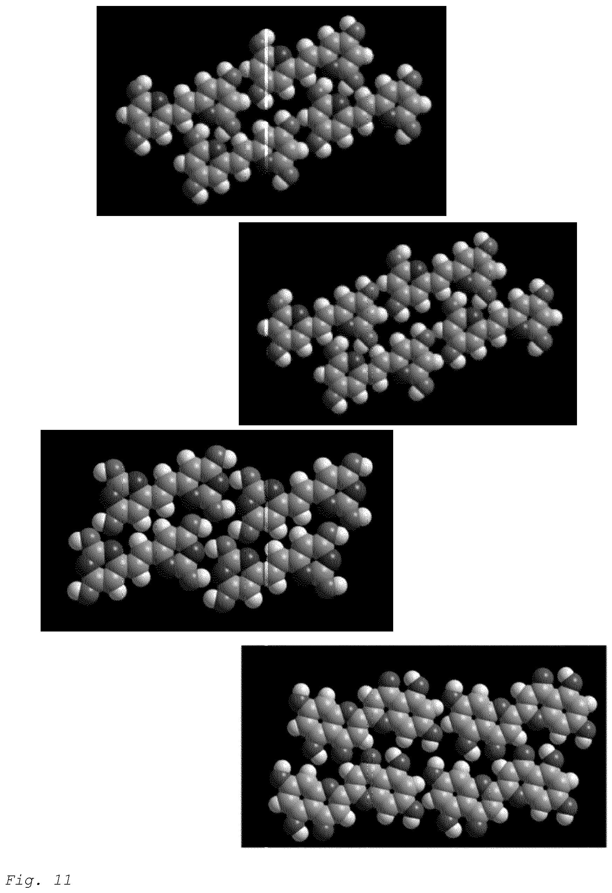

Weiterhin werden folgende Materialien offenbart, die sich durch eine Kombination mehrerer OH-Gruppen und mehreren N-H-Brücken je Molekül auszeichnen. Fig. 11 verdeutlicht die 2D-Anordnung einiger Materialien der folgenden Tabelle 4.

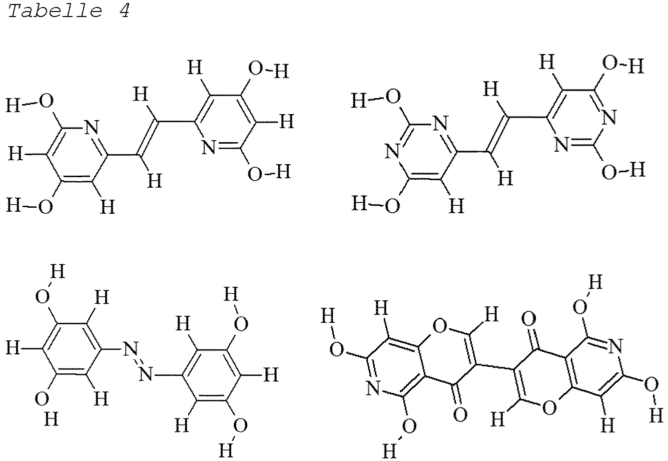

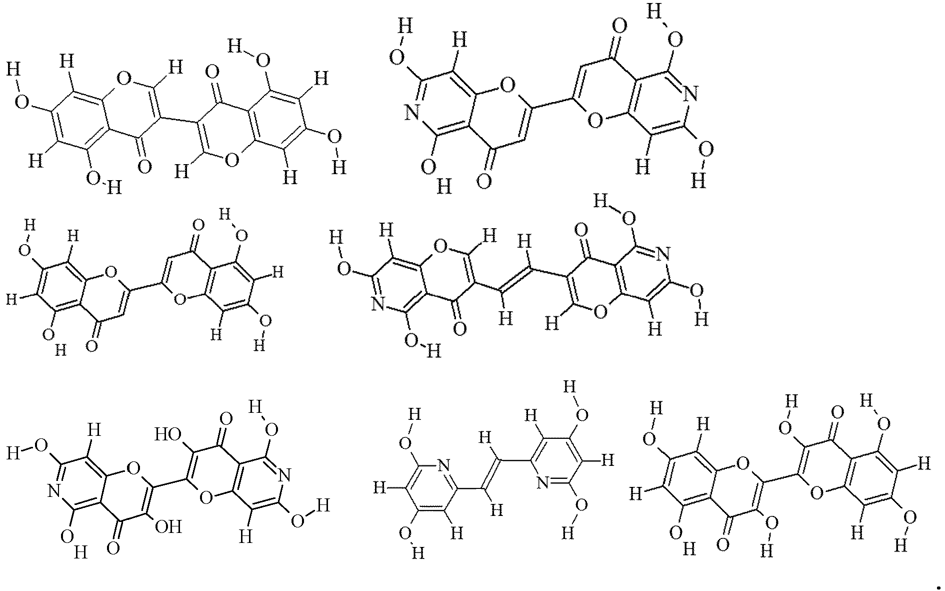

Weiterhin erfindungsgemäß ist die Herstellung organischer optoelektronischer Bauelemente mit Verbindungen gemäß einer der Strukturen (II.1), (II.2), (II.3) oder (II.4). Dem Fachmann sind die Schritte für die Herstellung organischer optoelektronischer Bauelemente bekannt. Deshalb ist erfindungsgemäß der zusätzliche Schritt, bei dem vor dem Auftragen mindestens einer Absorberschicht eine Templatschicht, umfassend mindestens eine der erfindungsgemäßen Verbindung, auf den bisher prozessierten Schichtstapel aufgebracht wird und danach erst die Absorberschicht aufgebracht wird. Dieser Schritt kann bei weiteren Absorberschichten innerhalb eines Schichtstapels des optoelektronischen Bauelements, sowohl innerhalb nur einer Zelle als auch in verschiedenen Zellen, wiederholt werden, wobei unterschiedliche oder gleiche Materialien in den Templatschichten verwendet werden können.

Alternativ kann mindestens eine erfindungsgemäße Verbindung auch gemeinsam mit einer oder mit mehreren Absorberschichten aufgebracht werden.

Das Aufbringen der erfindungsgemäßen Verbindungen kann beispielsweise
- durch Verdampfen vor dem Auftragen der Absorberschicht, bei Einsatz als Templateschicht, oder
- durch Aufbringen aus einer Lösung
erfolgen.

Eine Templatschicht mit mindestens einer der Verbindungen kann entweder nur in einer Zelle einer Tandem- oder Mehrfachzelle oder in mehreren Zellen einer Tandem- oder Mehrfachzelle vor dem Auftragen des Absorbermaterials in dieser Zelle erfolgen. Dabei können in den einzelnen Zellen, gleiche Templatmaterialien oder unterschiedliche Templatmaterialien vor dem Auftragen der Absorbermaterialien dieser Zelle beim Aufbau des Schichtstapels aufgetragen werden.

In weiteren Ausführungsform umfasst das organischen optoelektronischen Bauelement innerhalb einer Zelle einer Einzel-, Tandem- oder Mehrfachzelle mehrere Schichten mit gleichen oder unterschiedlichen erfindungsgemäßen Verbindungen.

Weiterhin erfindungsgemäß ist die Verwendung der Verbindungen gemäß den Strukturen (II.1), (II.2), (II.3) oder (II.4), in organischen optoelektronischen Bauelementen, wobei diese Materialien an mindestens ein Absorbermaterial einer photoaktiven Schicht grenzen.

Bevorzugt ist die Verwendung von Verbindungen gemäß der Struktur (II.4), oder Verbindungen gemäß der Tabelle 1, besonders bevorzugt ist die Verwendung von Ellagsäure.

In einer Ausführungsform erfolgt die Verwendung mindestens einer der eben genannten Materialien in einer Templatschicht, die direkt an eine anschließend aufgebrachte Absorberschicht grenzt.

Besonders bevorzugt ist die Verwendung nur eines erfindungsgemäß genutzten Materials in einer Templatschicht, die an eine anschließend aufgebrachte Absorberschicht grenzt.

### Ausführungsbeispiele

In den folgenden Ausführungsbeispielen wird die funktionelle Eignung der erfindungsgemäßen Verbindungen am Beispiel von Ellagsäure gezeigt.

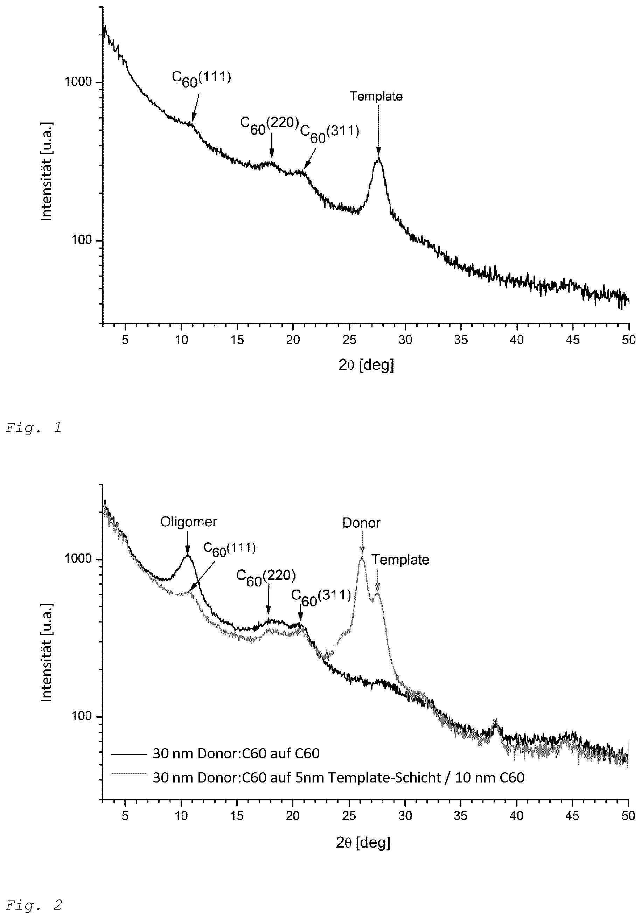

Fig. 1 zeigt das Ergebnis der Röntgendiffraktometrie mit streifendem Einfall (GIXRD) einer 5 nm dicken polyphenolhaltigen Schicht. Die Schichten wurden im Vakuum abgeschieden auf einem mit 10nm C60 beschichteten Si-Wafer.

Die Abscheidung der in Fig. 1 als Templat verwendeten Schicht erfolgte bei Raumtemperatur des Substrates. Die drei Bragg-Reflexe bei 2θ von 10,9°, 18,2° und 20,7° werden der kubischflächenzentrierten Phase (fcc) der C60-Unterschicht zugeordnet [Elschner, C. u.a.: Determining the C60 molecular arrangement in thin films by means of X-ray diffraction. Journal of Applied Crystallography, 44(5):983-990, 2011].

Der Reflex bei 27.6° wird der Templatschicht zugeordnet und deutet darauf hin, dass diese nanokristallin in pi-pi-Stapeln auf C60 wächst. Der Abstand zwischen den Kristallebenen entspricht 3.23 Ä. Somit sind die Templatmoleküle parallel zum Substrat ausgerichtet, die pi-pi Stapelrichtung ist senkrecht zum Substrat.

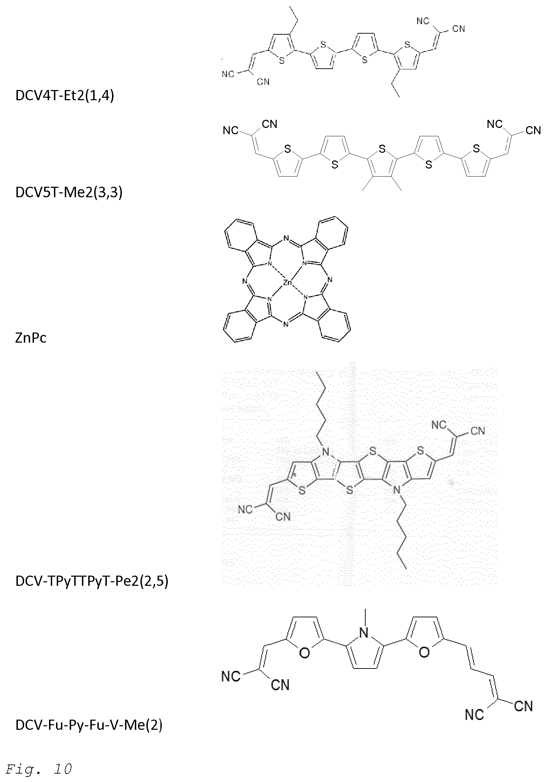

In Fig. 2 sind die Ergebnisse von GIXRD Messungen an einer 30 nm Donor:C60-Mischschicht, mit dem A-D-A-Oligomer DCV4T-Et2, vgl. Fig. 10 als Donor, abgeschieden auf 10 nm C60/Si-Substrat mit und ohne 5 nm Templatschicht dargestellt. Die Donor:C60 Mischschicht wurde bei einer Substrattemperatur von 40°C abgeschieden, das Mischungsverhältnis beträgt 2:1 Masse%. Diese Mischschicht wächst auf C60 nanokristallin.

Der Reflex bei 2θ = 10,8° wurde dem Donor zugeordnet und entspricht einen Abstand zwischen den Kristallebenen von 8,2 Ä. Dieser Wert deutet auf Donor-Moleküle hin, die schräg, d.h. edge-on zum Substrat orientiert sind [Guskova, O.: Light absorption in organic solar cells: The importance of oriented molecules, J. Phys. Chem. C, 2013, 117 (33), pp 17285-17293]. Da der (111)-Reflex von C60 bei 2θ = 10,8° liegt, könnte der detektierte Reflex bei 10,8° auch eine Überlagerung von Donor- und C60-Reflex darstellen. Das Röntgendiffraktogramm der Mischschicht aufgewachsen auf der Templatschicht zeigt den für das Templatmolekül Ellagsäure charakteristischen Reflex bei 27.6° (vergl. Fig. 1). Der Donor-Reflex bei 2θ = 10,8° ist nicht mehr vorhanden oder ist signifikant abgeschwächt. Stattdessen zeigt das Diffraktogramm einen neuen starken Reflex bei 2θ = 26,1° und eine Schulter bei 24,6°. Der Kristallebenen-Abstand für den Reflex bei 26,1° entspricht 3,4 Ä und deutet somit auf ein face-on Wachstum oder zumindest auf stark zum Substrat gekippte Orientierung der Donormoleküle hin. Die mittlere Größe der Donor-Kristallite wurde mit Hilfe der Scherrer-Gleichung ausgewertet und beträgt 8,1 nm.

Somit beweisen die Messergebnisse, dass die Orientierung der Donor-Moleküle durch die Templatschicht beeinflusst wurde und die Kristallinität der Donor-Phase in der Mischschicht verbessert wurde.

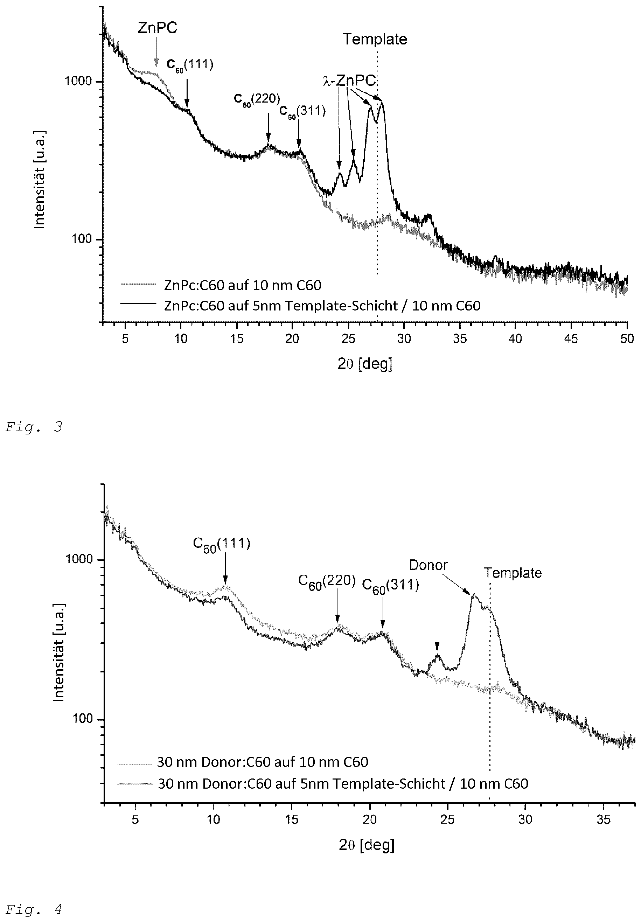

Fig. 3 zeigt Messergebnisse von GIXRD-Untersuchungen an Zink-Phthalocyanin (ZnPc) gemischt mit C60 in einer ZnPc:C60 Mischschicht, gewachsen auf 10 nm C60/Si-Substrat mit und ohne 5 nm Templatschicht. Die 30 nm dicken Mischschichten wurden auf 70°C geheiztem Substrat abgeschieden, das Mischungsverhältnis beträgt 1:1. Für beide Proben sind die drei charakteristische Reflexe der kubisch-flächenzentrierte (fcc) Phase der C60-Unterschicht bei 2θ = 10,9°, 18,2°, 20,7° gut erkennbar. Die ZnPc:C60 Mischschicht abgeschieden direkt auf C60 zeigt zwei amorphe ZnPc-Signale bei 2θ = 7,7° und 2θ = 28,6°. Bei der auf der Templatschicht abgeschiedenen Probe verschwindet die Charakteristik bei 7,7° und neue Bragg-Reflexe bei größeren 2θ-Winkeln zwischen 24° und 29° treten auf. In Fig. 3 sind diese mit λ-ZnPc bezeichnet. Die Zuordnung der Reflexe erfolgte anhand der Veröffentlichung von [Schünemann, C. u.a.: Evaluation and Control of the Orientation of Small Molecules for Strongly Absorbing Thin Films. The Journal of Physical Chemistry C 2013, 117, 11600-11609]. Die mit λ bezeichneten Reflexe entsprechen auf dem Substrat flach-liegenden ZnPc-Molekülen (face-on-Wachstum). Die berechneten Abstände zwischen parallelen Kristallebenen liegen im Bereich 3.2 Å bis 3.7 Ä.

Dementsprechend führt die dünne Templatschicht zur Änderung der Orientierung von stehend nach face-on und zur Verbesserung der Kristallinität der ZnPc-Moleküle.

Fig. 4 stellt Ergebnisse der GIXRD Messungen an Donor:C60 Mischschichten, mit DCV5T-Me2(3,3) als Donor, abgeschieden auf 10 nm C60 mit und ohne Templatschicht dar. Die 30 nm dicken Mischschichten wurden auf 80°C geheiztem Substrat abgeschieden, das Mischungsverhältnis beträgt 2:1. Das Röntgendiffraktogramm zeigt für beide Donor:C60 Mischschichten die charakteristischen Peaks der C60 fcc-Phase. Der Donor in der Mischschicht, aufgedampft direkt auf C60 wächst amorph. Im Gegensatz dazu zeigen sich auf der Templatschicht Reflexe im 2θ-Bereich zwischen 24° und 30°. Diese sind der Donor-Phase in der Mischschicht und der Templatschicht zugeordnet. Dementsprechend wächst der Donor auf der Templatschicht kristallin. Die Reflexe zwischen 24° und 30° entsprechen Bragg-Abständen von 3,7 Å und 3,4 Å.

Diese Werte deuten auf flach-liegende (face-on) oder zumindest stark zum Substrat geneigte Donormoleküle hin.

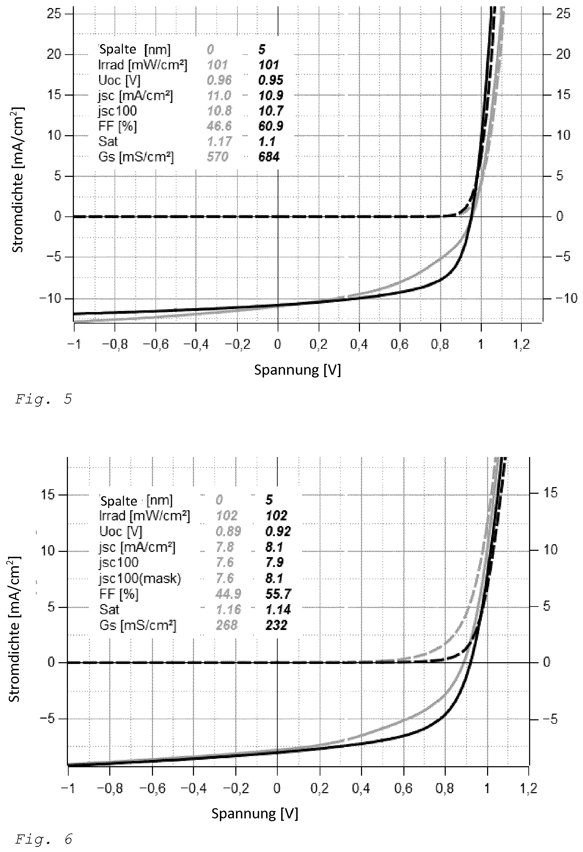

Fig. 5 sind die Messergebnisse von Solarzellen dargestellt, die eine photoaktiven Schicht aus Donor:C60 (Donor = DCV4T-Et2) enthalten. Die photoaktive Schicht weist eine Dicke von 30 nm auf. Die Abscheidung der photoaktiven Schicht erfolgte bei einer Substrattemperatur von 40°C. Das Mischungsverhältnis zwischen Donor und C60 beträgt 2:1. Die grau dargestellte Kurve zeigt die Strom-Spannungskennlinie eines Bauelements, in dem die photoaktive Schicht direkt auf C60 abgeschieden wurde und die schwarz dargestellte Kurve zeigt die Strom-Spannungskennlinie eines Bauelements mit photoaktiver Schicht abgeschieden auf einer 5 nm dicken Templatschicht. Für die Zelle mit der Templatschicht zeigt sich eine Erhöhung des Füllfaktors um 13,6% (von 45,2% auf 58,8%). Diese ist in Übereinstimmung mit den Ergebnissen der GIXRD Messung (Fig. 2) auf die verbesserte Kristallinität der photoaktiven Schicht zurückzuführen. Die Templatschicht führt folglich zu einer deutlich verbesserten Solarzelle.

Fig. 6 zeigt die Messergebnisse von zwei Solarzellen mit einer photoaktiven Schicht von Donor:C60 (DCV4T-Et2:C60). Die photoaktive Schicht weist eine Dicke von 30 nm auf. Ihre Abscheidung erfolgte bei einer Substrattemperatur von 70°C. Die graue Kennlinie zeigt die Strom-Spannungskennlinie des Bauelements, bei dem die Donor:C60-Schicht direkt auf C60 abgeschieden wurde und die schwarze Kennlinie zeigt die Strom-Spannungskennlinie eines Bauelements mit Donor:C60 Schicht abgeschieden auf einer 5nm dicken Templatschicht. Der Füllfaktor der Solarzelle mit der Templatschicht liegt bei 55,7%, im Vergleich dazu hat die Solarzelle ohne Templatschicht einen geringeren Füllfaktor von 44,9%.

Der Anstieg des Füllfaktors ist bedingt durch die verbesserte Nahordnung der Donor-Phase in der photoaktiven Schicht, gewachsen auf der Templatschicht. Mit Templat steigt zudem Voc, lediglich Jsc sinkt leicht. Insgesamt verbessert sich durch das Templat die Zelleffizienz PCE = Voc * jsc *FF.

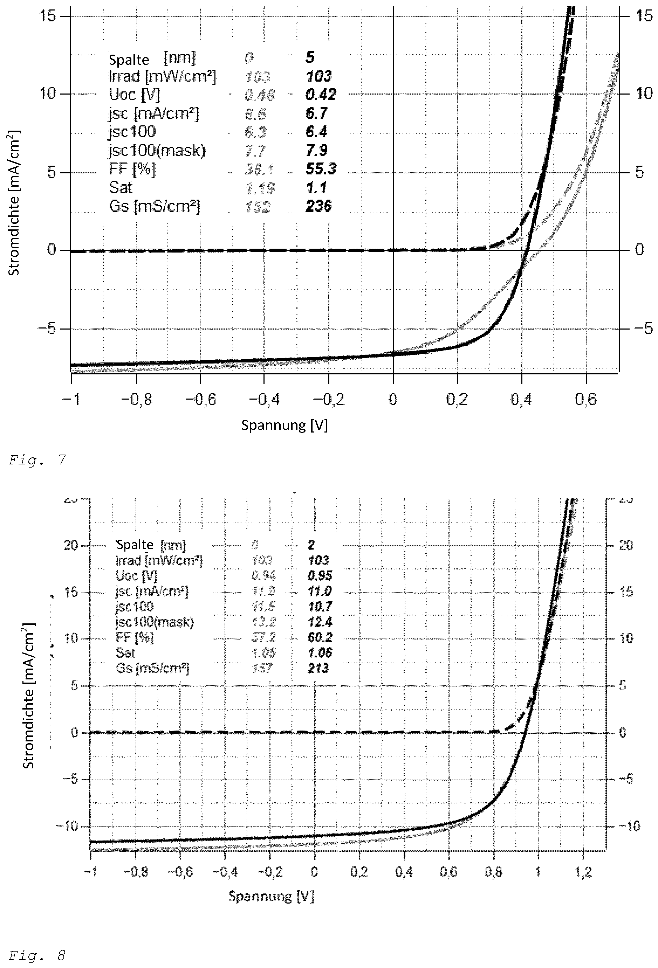

Fig. 7 zeigt die Messergebnisse zweier Solarzellen, die als photoaktive Schicht ZnPc:C60 enthalten. Die photoaktive Schicht weist eine Dicke von 30 nm auf. Ihre Abscheidung erfolgte bei einer Substrattemperatur von 70°C. Die graue Kurve stellt die Strom-Spannungskennlinie des Bauelements dar, in dem die ZnPc:C60-Schicht direkt auf C60 abgeschieden wurde, wogegen die schwarze Kurve die Strom-Spannungskennlinie eines Bauelements mit ZnPc:C60 Schicht, abgeschieden auf einer 5 nm dicken Templatschicht zeigt. Die Solarzelle ohne Templatschicht hat einen Füllfaktor von 36,1%, im Gegensatz dazu hat die Zelle mit Templatschicht einen deutlich besseren Füllfaktor von 55,3%. Gemäß den GIXRD-Daten (siehe Fig. 3) ist der verbesserte Füllfaktor auf die von der Templatschicht hervorgerufene Kristallinität der ZnPc-Phase in der Mischschicht zurückzuführen.

Zwar sinken Voc und jsc leicht, aber der Gesamt-Wirkungsgrad PCE = Voc * jsc * FF wird mit der Templatschicht insgesamt besser.

In Fig. 8 sind die Messergebnisse von Solarzellen, die eine photoaktive Schicht aus Donor:C60 (Donor = DCV-TPyTTPyT-Pe2(2,5)) enthalten dargestellt. Die photoaktive Schicht weist eine Dicke von 30nm auf. Die Abscheidung der photoaktiven Schicht erfolgte bei einer Substrattemperatur von 70°C. Das Mischungsverhältnis zwischen Donor und C60 beträgt 2:1. Die graue Kurve in Fig. 8 zeigt die Strom-Spannungskennlinie eines Bauelements, in dem die photoaktive Schicht direkt auf C60 abgeschieden wurde, und die schwarze Kurve die Strom-Spannungskennlinie eines Bauelements mit einer photoaktiven Schicht abgeschieden auf einer 2 nm dicken Templatschicht. Für die Zelle mit der Templatschicht zeigt sich eine Erhöhung des Füllfaktors im Vergleich zu der Zelle ohne Templatschicht von 57,2% auf 60,2%. Dieses beruht auf einem verbesserten Kristallisationsgrad der Donor-Phase in der Mischschicht, bedingt durch die Wechselwirkung mit der kristallinen Templatschicht. Der Gesamt-Wirkungsgrad PCE = Voc * jsc * FF bleibt hingegen nahezu unverändert, da die Probe mit Templatschicht einen geringeren Strom zeigt.

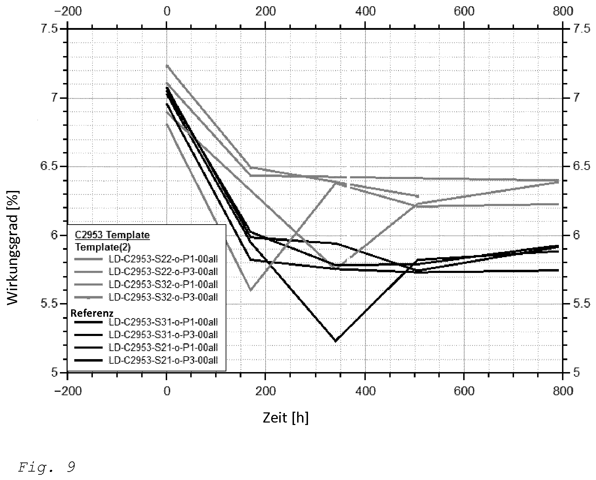

Fig. 9 zeigt als einen überraschenden Befund die Ergebnisse der Lebensdauermessungen von Bulk Heterojunction Solarzellen nach 800 Stunden beschleunigter Alterung im Ofen bei 85°C. Die Solarzellen enthalten als photoaktive Schicht Donor:C60 *(Donor = DCV-Fu-Py-Fu-V-Me(2))* mit Mischungsverhältnis 2:3. Sie sind auf ITO-beschichtetem Glassubstrat hergestellt und haben die Schichtfolge ITO / n-C60 / C60 / Templat (0 oder 2 nm) / Donor:C60 (30 nm) / Lochleiter / p-dotierter Lochleiter / Injektionsschicht / Deck-Elektrode (Al). Die Donor:C60 Mischschicht wurde direkt auf der intrinsischen C60 Schicht oder auf einer Templatschicht abgeschieden.

Für beide Solarzellen wurde einen Initialabfall des Wirkungsgrads beobachtet, danach bleiben die Solarzellen stabil. Der Initialabfall ist mit 17% für die Referenzzellen ohne Templatschicht am stärksten ausgeprägt. Dagegen beträgt der Abfall für die Solarzellen mit Templatschicht nur 8 %. Die Effizienzabnahme ist auf den Abfall des Füllfaktors zurückzuführen.

Somit deuten die Messergebnisse auf eine stabilisierende Wirkung der Templatschicht auf die Lebensdauer der Solarzellen hin. Eine mögliche Erklärung ist die Ausbildung eines stabileren Füllfaktors durch die bevorzugte Molekülorientierung, die mit dem Templatmaterial erzielt wird.

## Patentansprüche

1. Organisches optoelektronisches Bauelement, umfassend zwei Elektroden und dazwischen angeordnet mindestens ein photoaktives Schichtsystem, dieses umfassend mindestens eine photoaktive Schicht, umfassend Absorbermaterialien auf der Basis kleiner Moleküle, wobei das Absorbermaterial A-D-A-Moleküle sind, **dadurch gekennzeichnet, dass**
die photoaktive Schicht an eine Templatschicht angrenzt, wobei die Templatschicht eine Verbindung der Struktur (II.1), (II.2), (II.3) und/oder (II.4) umfasst,
wobei: 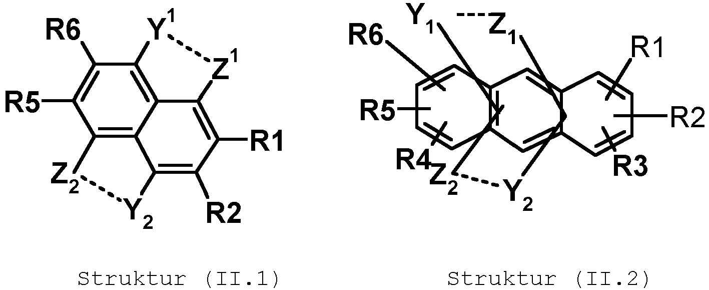 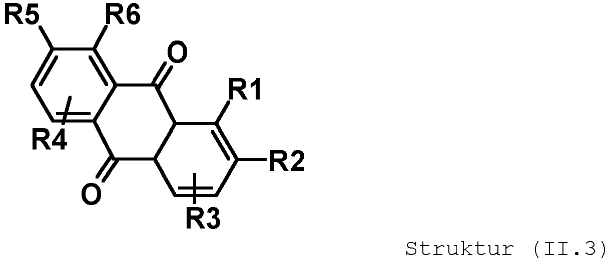 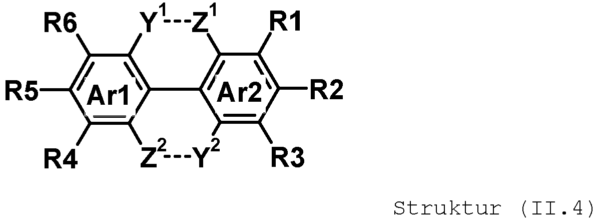
Ar1 und Ar2 zwei oder mehr verbundene aromatische oder heteroaromatische Ringe (Ar1, Ar2), bevorzugt Benzolringe, sind, die jeweils mindestens zwei Hydroxygruppen und/oder Aminogruppen umfassen,
R1 bis R6 ausgewählt sind aus H, OH, NH₂;
Y1 ausgewählt ist aus CH, CH₂, CO;
Y2 ausgewählt ist aus CH, CH₂, CO, H;
Z1 ausgewählt ist aus CH, CH₂, CO, O, NH;
Z2 ausgewählt ist aus CH, CH₂, CO, O, NH, H;
wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

2. Organisches optoelektronisches Bauelement nach Anspruch 1, **dadurch gekennzeichnet, dass** die mindestens eine Verbindung der Struktur (II.1), (II.2), (II.3) und/oder (II.4) ausgewählt ist aus der Gruppe bestehend aus

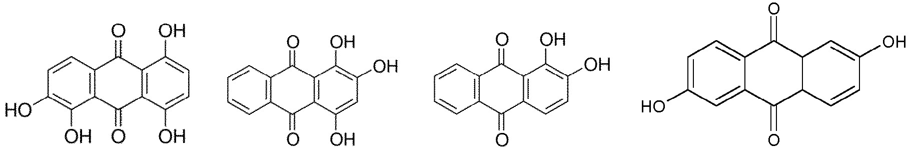

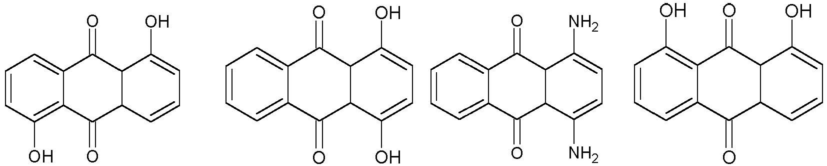

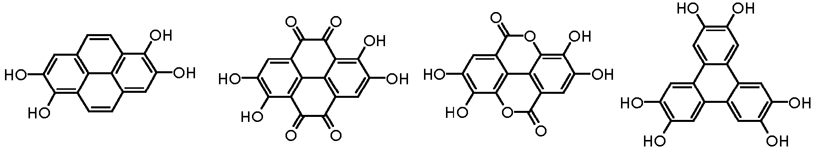

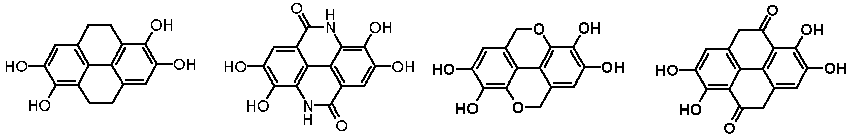

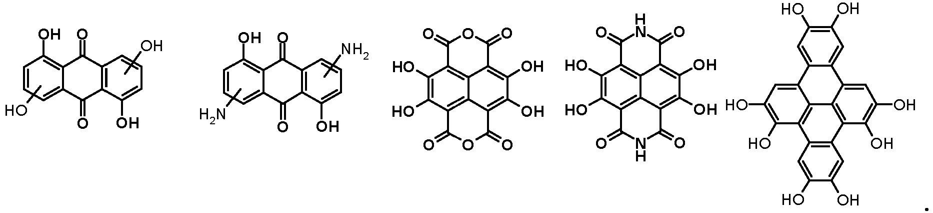

3. Organisches optoelektronisches Bauelement gemäß Anspruch 1 oder 2, **dadurch gekennzeichnet, dass** die Templatschicht die mindestens eine Verbindung der Struktur (II.1), (II.2), (II.3) und/oder (II.4) umfasst, wobei die Templatschicht vor der Absorberschicht aufgebracht ist.

4. Organisches optoelektronisches Bauelement gemäß einem der vorhergehenden Ansprüche, wobei das organische optoelektronische Bauelement eine Tandem- oder Mehrfachzelle ist.

5. Organisches optoelektronisches Bauelement gemäß Anspruch 4, wobei das organische optoelektronische Bauelement verschiedene Schichten mit gleichen oder unterschiedlichen Verbindungen gemäß den Ansprüchen 1 oder 2 umfasst.

6. Organisches optoelektronisches Bauelement gemäß einem der vorhergehenden Ansprüche, **dadurch gekennzeichnet, dass** das organische optoelektronische Bauelement eine organische Solarzelle oder ein organischer Photodetektor ist, und die Templatschicht Ellagsäure umfasst.

7. Herstellung des organischen optoelektronischen Bauelements gemäß einem der vorhergehenden Ansprüche, **dadurch gekennzeichnet, dass** während der Herstellung der Schichten des organischen optoelektronischen Bauelements
a) vor dem Auftragen mindestens einer Absorberschicht die Templatschicht, umfassend die mindestens eine Verbindung der Struktur (II.1), (II.2), (II.3) und/oder (II.4), auf bisher abgeschiedene Schichten aufgetragen wird, und/oder
b) gleichzeitig mit den Absorbermaterialien der mindestens einen Absorberschicht die mindestens eine Verbindung der Struktur (II.1), (II.2), (II.3) und/oder (II.4) auf bisher aufgebrachte Schichten aufgetragen wird.

8. Verwendung von mindestens einer Verbindung der Struktur (II.1), (II.2), (II.3) und/oder (II.4) in einem organischen optoelektronischen Bauelement, umfassend mindestens eine photoaktive Schicht, diese umfassend mindestens ein Absorbermaterial auf der Basis kleiner Moleküle, wobei das Absorbermaterial A-D-A-Moleküle sind, wobei die mindestens eine Verbindung gemäß der Struktur (II.1), (II.2), (II.3) und/oder (II.4) an das Absorbermaterial grenzt, wobei: 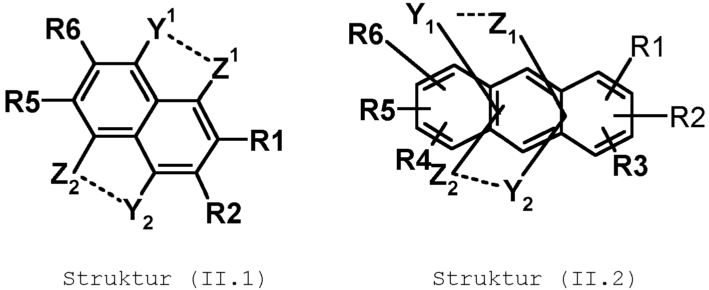 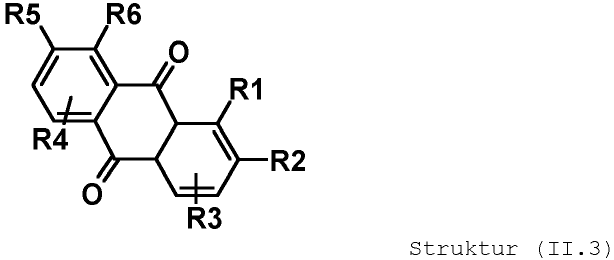 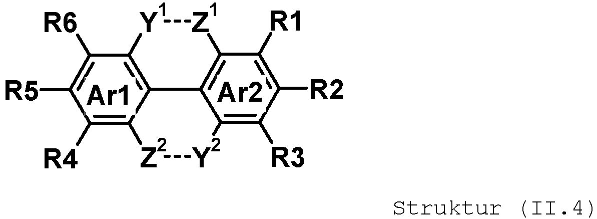
Ar1 und Ar2 zwei oder mehr verbundene aromatische oder heteroaromatische Ringe (Ar1, Ar2), bevorzugt Benzolringe, sind, die jeweils mindestens zwei Hydroxygruppen und/oder Aminogruppen umfassen,
R1 bis R6 ausgewählt sind aus H, OH, NH₂;
Y1 ausgewählt ist aus CH, CH₂, CO;
Y2 ausgewählt ist aus CH, CH₂, CO, H;
Z1 ausgewählt ist aus CH, CH₂, CO, O, NH;
Z2 ausgewählt ist aus CH, CH₂, CO, O, NH, H;
wobei die Verknüpfungen Y1 ... Z1 und/oder Y2 ... Z2 sowohl kovalenter als auch nicht kovalenter Natur sein, wobei im ersten (kovalenten) Fall Y1 ... Z1 und/oder Y2 ... Z2 ebenso eine substituierte aromatische oder heteroaromatische Mono-, Di- oder Trihydroxyverbindung bilden können.

9. Verwendung gemäß Anspruch 8, **dadurch gekennzeichnet, dass** die mindestens eine Verbindung der Struktur (II.1), (II.2), (II.3) und/oder (II.4) zur Verbesserung der Morphologie angrenzender Absorbermoleküle genutzt wird, wobei die mindestens eine Verbindung in einer Templatschicht vor der angrenzenden Absorberschicht aufgebracht ist, wobei bevorzugt Ellagsäure in der Templatschicht verwendet wird.

## Claims

1. Organic optoelectronic component comprising two electrodes and at least one photoactive layer system in between that comprising at least one photoactive layer comprising absorber materials based on small molecules, wherein the absorber material is A-D-A molecules, **characterized in that**
the photoactive layer adjoins a template layer, wherein the template layer comprises a compound of structure (II.1), (II.2), (II.3) and/or (II.4),
wherein: 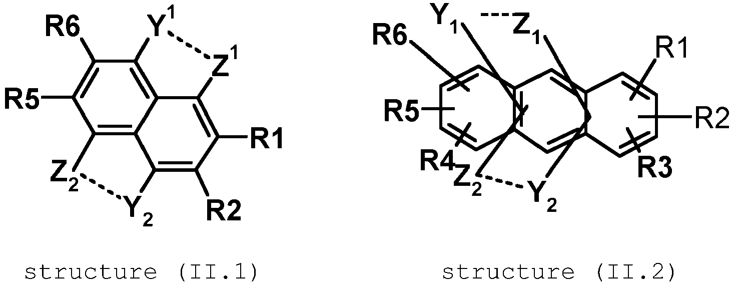 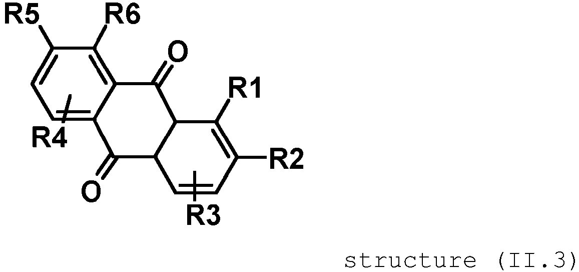 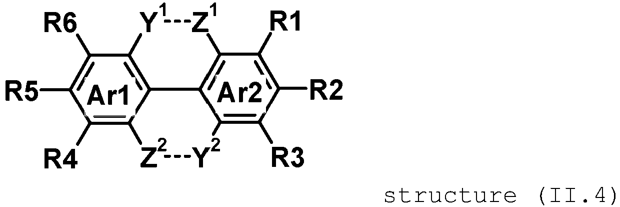
Ar1 and Ar2 are two or more bonded aromatic or heteroaromatic rings (Ar1, Ar2), preferably benzene rings, each comprising at least two hydroxyl groups and/or amino groups,
R1 to R6 are selected from H, OH, NH₂;
Y1 is selected from CH, CH₂, CO;
Y2 is selected from CH, CH₂, CO, H;
Z1 is selected from CH, CH₂, CO, O, NH;
Z2 is selected from CH, CH₂, CO, O, NH, H;
wherein the linkages Y1 ... Z1 and/or Y2 ... Z2 are either covalent or non-covalent, wherein in the first (covalent) case Y1 ... Z1 and/or Y2 ... Z2 may likewise form a substituted aromatic or heteroaromatic mono-, di- or trihydroxy compound.

2. Organic optoelectronic component according to Claim 1, **characterized in that** the at least one compound of the structure (II.1), (II.2), (II.3) and/or (II.4) is selected from the group consisting of

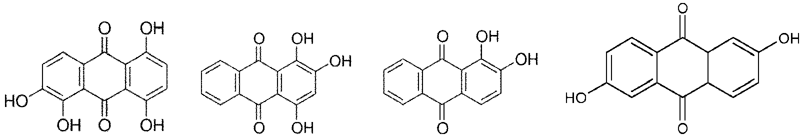

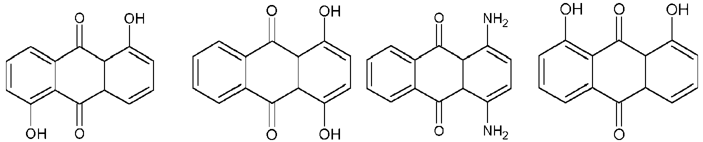

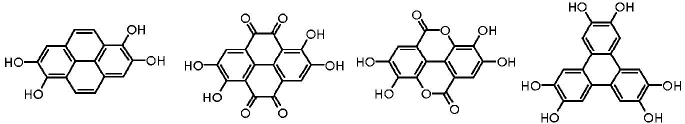

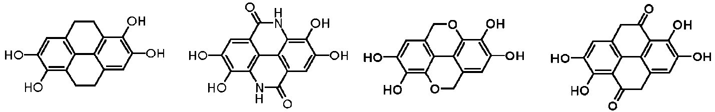

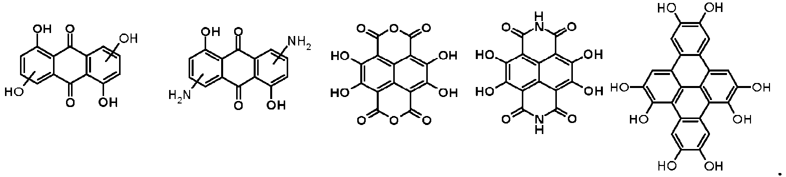

3. Organic optoelectronic component according to Claim 1 or 2, **characterized in that** the template layer comprises the at least one compound of the structure (II.1), (II.2), (II.3) and/or (II.4), wherein the template layer is applied before the absorber layer.

4. Organic optoelectronic component according to any of the preceding claims, wherein the organic optoelectronic component is a tandem cell or multiple cell.

5. Organic optoelectronic component according to Claim 4, wherein the organic optoelectronic component comprises various layers having identical or different compounds according to Claim 1 or 2.

6. Organic optoelectronic component according to any of the preceding claims, **characterized in that** the organic optoelectronic component is an organic solar cell or an organic photodetector, and the template layer comprises ellagic acid.

7. Manufacture of the organic optoelectronic component according to any of the preceding claims, **characterized in that** during the manufacturing of the layers of the organic optoelectronic component,
a) before the applying of at least one absorber layer, the template layer comprising the at least one compound of the structure (II.1), (II.2), (II.3) and/or (II.4) is applied to layers deposited beforehand, and/or
b) simultaneously with the absorber materials of the at least one absorber layer, the at least one compound of the structure (II.1), (II.2), (II.3) and/or (II.4) is applied to layers applied beforehand.

8. Use of at least one compound of the structure (II.1), (II.2), (II.3) and/or (II.4) in an organic optoelectronic component comprising at least one photoactive layer that comprises at least one absorber material based on small molecules, wherein the absorber material are A-D-A molecules, wherein the at least one compound of the structure (II.1), (II.2), (II.3) and/or (II.4) adjoins the absorber material, wherein: 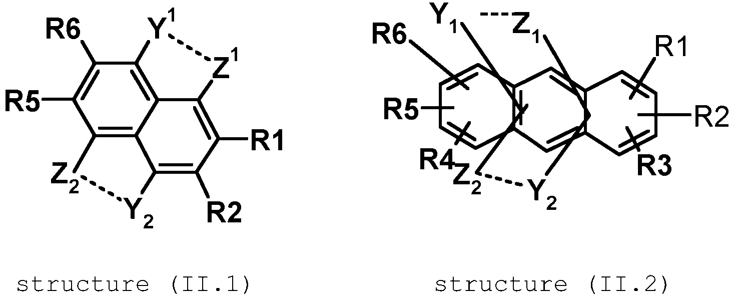 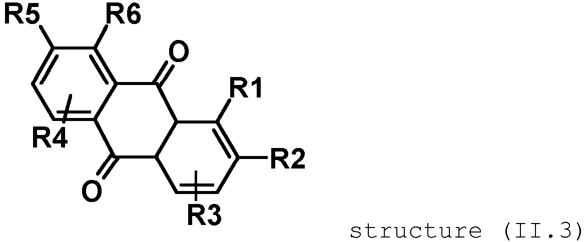 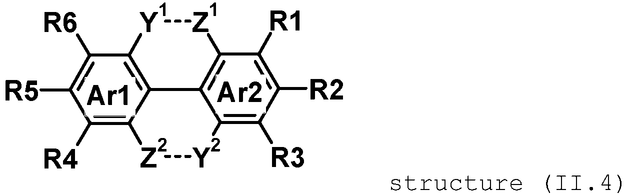
Ar1 and Ar2 are two or more bonded aromatic or heteroaromatic rings (Ar1, Ar2), preferably benzene rings, each comprising at least two hydroxyl groups and/or amino groups,
R1 to R6 are selected from H, OH, NH₂;
Y1 is selected from CH, CH₂, CO;
Y2 is selected from CH, CH₂, CO, H;
Z1 is selected from CH, CH₂, CO, O, NH;
Z2 is selected from CH, CH₂, CO, O, NH, H;
wherein the linkages Y1 ... Z1 and/or Y2 ... Z2 are either covalent or non-covalent, wherein in the first (covalent) case Y1 ... Z1 and/or Y2 ... Z2 may likewise form a substituted aromatic or heteroaromatic mono-, di- or trihydroxy compound.

9. Use according to Claim 8, **characterized in that** the at least one compound of the structure (II.1), (II.2), (II.3) and/or (II.4) is used to improve the morphology of adjacent absorber molecules, wherein the at least one compound is arranged in a template layer in front of the adjacent absorber layer, wherein preferably ellagic acid is used in the template layer.

## Revendications

1. Composant optoélectronique organique comprenant deux électrodes et au moins un système de couches photo-actives intercalé entre celles-ci, qui comprend au moins une couche photo-active comprenant des matériaux absorbants à base de petites molécules, le matériau absorbant A-D-A étant des molécules, **caractérisé en ce que**
la couche photo-active jouxte une couche de gabarit, la couche de gabarit comprenant un composé de la structure (II.1), (II.2), (II.3) et/ou (II.4), 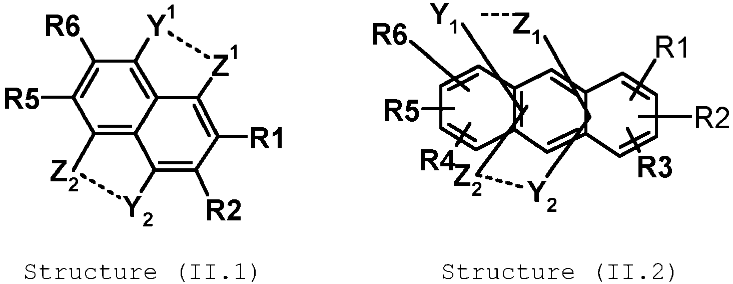 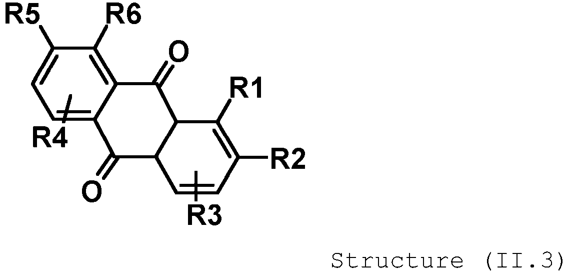 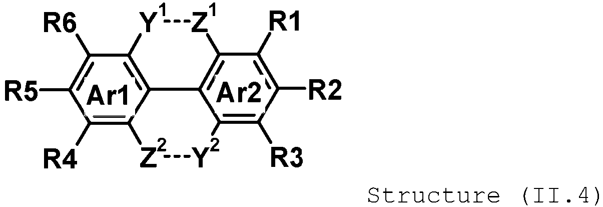
Ar1 et Ar2 étant deux ou plusieurs cycles aromatiques ou hétéroaromatiques (Ar1, Ar2) liés, de manière préférée des cycles benzéniques, qui comprennent chacun au moins deux groupes hydroxy et/ou groupes amino,
R1 à R6 étant choisis parmi H, OH, NH₂ ;
Y1 étant choisi parmi CH, CH₂, CO ;
Y2 étant choisi parmi CH, CH₂, CO, H ;
Z1 étant choisi parmi CH, CH₂, CO, O, NH ;
Z2 étant choisi parmi CH, CH₂, CO, O, NH, H ;
les liaisons Y1 ... Z1 et/ou Y2 ... Z2 étant toutes deux à la fois covalentes et non covalentes, Y1 ... Z1 et/ou Y2 ... Z2 pouvant, dans le premier cas (covalent), également former un composé mono-, di- ou trihydroxy aromatique ou hétéroaromatique substitué.

2. Composant optoélectronique organique selon la revendication 1, **caractérisé en ce que** l'au moins un composé de la structure (II.1), (II.2), (II.3) et/ou (II.4) est choisi dans le groupe constitué par

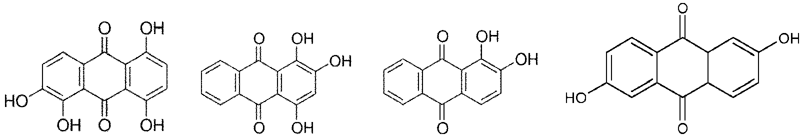

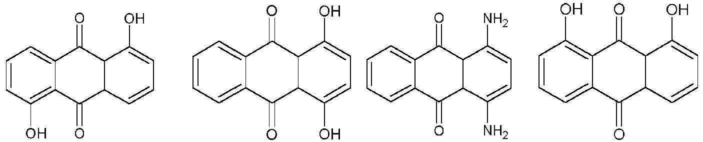

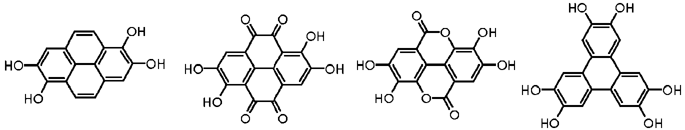

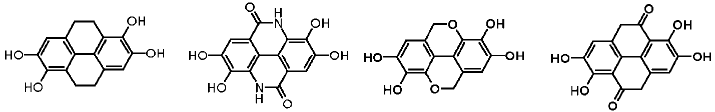

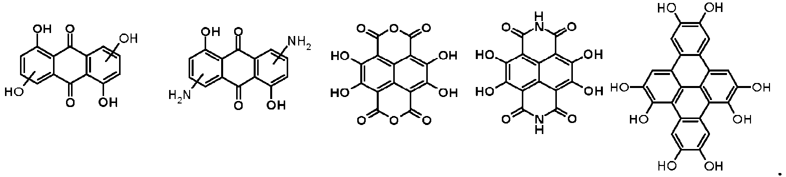

3. Composant optoélectronique organique selon la revendication 1 ou 2, **caractérisé en ce que** la couche de gabarit comprend au moins un composé de la structure (II.1), (II.2), (II.3) et/ou (II.4), la couche de gabarit étant appliquée avant la couche d'absorption.

4. Composant optoélectronique organique selon l'une des revendications précédentes, dans lequel le composant optoélectronique organique est une cellule tandem ou multiple.

5. Composant optoélectronique organique selon la revendication 4, le composant optoélectronique organique comprenant différentes couches avec des composés identiques ou différents selon les revendications 1 ou 2.

6. Composant optoélectronique organique selon l'une des revendications précédentes, **caractérisé en ce que** le composant optoélectronique organique est une cellule solaire organique ou un photodétecteur organique, et la couche de gabarit comprend de l'acide ellagique.

7. Fabrication du composant optoélectronique organique selon l'une des revendications précédentes, **caractérisée en ce que** lors de la fabrication des couches du composant optoélectronique organique
a) avant d'appliquer au moins une couche d'absorption, la couche de gabarit comprenant l'au moins un composé de la structure (II.1), (II.2), (II.3) et/ou (II.4) est appliquée sur des couches déposées jusqu'ici, et/ou
b) en même temps que les matériaux absorbants de l'au moins une couche d'absorption, l'au moins un composé de la structure (II.1), (II.2), (II.3) et/ou (II.4) est appliqué sur des couches appliquées jusqu'ici.

8. Utilisation d'au moins un composé de la structure (II.1), (II.2), (II.3) et/ou (II.4) dans un composant optoélectronique organique comprenant au moins une couche photo-active comprenant au moins un matériau absorbant à base de petites molécules, le matériau absorbant étant des molécules A-D-A, l'au moins un composé selon la structure (II.1), (II.2), (II.3) et/ou (II.4) jouxtant le matériau absorbant : 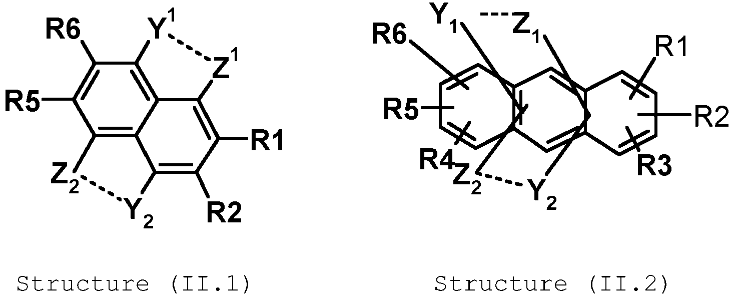 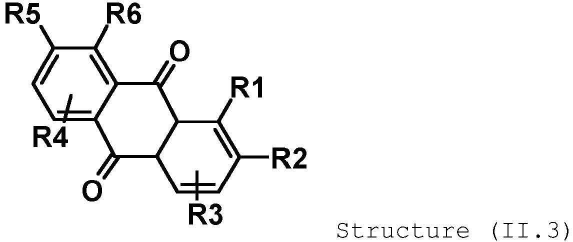 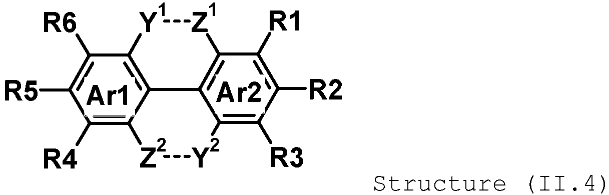
Ar1 et Ar2 étant deux ou plusieurs cycles aromatiques ou hétéroaromatiques (Ar1, Ar2) liés, de manière préférée des cycles benzéniques, qui comprennent chacun au moins deux groupes hydroxy et/ou groupes amino,
R1 à R6 étant choisis parmi H, OH, NH₂ ;
Y1 étant choisi parmi CH, CH₂, CO ;
Y2 étant choisi parmi CH, CH₂, CO, H ;
Z1 étant choisi parmi CH, CH₂, CO, O, NH ;
Z2 étant choisi parmi CH, CH₂, CO, O, NH, H ;
les liaisons Y1 ... Z1 et/ou Y2 ... Z2 étant toutes deux à la fois covalentes et non covalentes, Y1 ... Z1 et/ou Y2 ... Z2 pouvant, dans le premier cas (covalent), également former un composé mono-, di- ou trihydroxy aromatique ou hétéroaromatique substitué.

9. Utilisation selon la revendication 8, **caractérisée en ce que** l'au moins un composé de structure (II.1), (II.2), (II.3) et/ou (II.4) est utilisé pour améliorer la morphologie de molécules absorbantes adjacentes, l'au moins un composé d'une couche de gabarit étant appliqué avant la couche d'absorption adjacente, de l'acide ellagique étant de manière préférée utilisé dans la couche de gabarit.
